# EUROPÄISCHE PATENTSCHRIFT

(11) **EP 2 791 980 B1**
(45) Veröffentlichungstag und Bekanntmachung des Hinweises auf die Patenterteilung: **27.07.2016**
(21) Anmeldenummer: 12794225.8
(22) Anmeldetag: 19.11.2012
(51) Int. Cl.: H01L 31/042

(54) **SCHWIMMENDE ABDECKFOLIE MIT SOLARMODUL**
FLOATING COVER SHEET WITH SOLAR MODULE
FEUILLE DE COUVERTURE FLOTTANTE À MODULE SOLAIRE

(30) Priorität: 12.12.2011 DE 102011056284
(43) Veröffentlichungstag der Anmeldung: 22.10.2014
(73) Patentinhaber: Benecke-Kaliko AG, 30419 Hannover (DE)
(72) Erfinder: HAARBURGER, Tobias, 30167 Hannover (DE); STÖLTING, Andreas, 30989 Gehrden (DE)
(74) Vertreter: Kilsch, Armin Ralph
(86) Internationale Anmeldenummer: PCT/EP2012/072962
(87) Internationale Veröffentlichungsnummer: WO 2013/087361

(56) Entgegenhaltungen:
- WO-A2-2009/045066
- DE-A1-102009 008 067
- US-A1- 2011 168 235

## Beschreibung

Die Erfindung betrifft eine schwimmende Abdeckfolie eines Flüssigkeitsreservoirs, die auf der Flüssigkeitsoberfläche des Reservoirs aufliegt und die mit einem Solarmodul, vorzugsweise einer Dünnschicht-Photovoltaik versehen ist.

Photovoltaische Systeme in Verbindung mit Abdeckungen von Wasseroberflächen oder in Wasser eingetauchte photovoltaische Systeme sind im Stand der Technik bekannt. Das Dokument US 2011/168235A beschreibt ein photovoltaische Module.

So offenbart die WO 2008/012791 A1 ein in Wasser integriertes bzw. zur Verwendung in einer Wasser-Umgebung angepasstes photovoltaisches System, bei dem Photovoltaik-Zellen auf einer Folie, einer so genannten Geofolie angebracht sind. Die Geofolie kann dabei auf dem Wasser schwimmend angeordnet sein oder soweit in Wasser eingetaucht schweben, dass die Photovoltaik-Zellen auf der Folie von Wasser überspült und somit gereinigt und gekühlt werden. Unterschiedliche UV resistente Beschichtungsmaterialien aus Polymeren sind ebenso offenbart wie eine aufblasbare Geofolie.

Die US 2010/0294331 Aloffenbart eine Anordnung von Photovoltaik-Zellen, eingebettet in einer Membrane oder angeordnet auf einer Membrane, welche als Abdeckung auf eine Wasserreservoir gelegt wird, also etwa auf die Oberfläche eines Swimmingpools oder eines Teiches, und welche dann der Energieerzeugung dient. Das System als ganzes schwimmt auf dem Wasser oder kann auch eingetaucht betrieben werden.

Die WO 2010/026542 A1 Aloffenbart zur Erzeugung von elektrischer Energie eine Anordnung von Photovoltaik-Zellen auf einer in Wasser eingetauchten oder auf dem Wasser schwimmenden plattenförmigen festen Struktur (panel). Die Tauchtiefe der Struktur kann beliebig eingestellt werden von "Schwimmen" auf der Oberfläche bis "Tauchen" in z.B. zwei Metern Tiefe. Die Photovoltaik-Zellen können flach aufgelegt oder über Gestänge verstellbar ausgebildet sein.

Die DE 198 57 174 A1 offenbart ein im Wasser schwimmendes Solarfoliensystem, bei dem die die Photovoltaik tragende Folie zwischen einer unteren Bodenfolie und einer transparenten Deckfolie eingeschweißt ist und bei dem zwischen den Folien Zwischenräume vorgesehen sind, die einerseits zur Regulierung der Eintauchtiefe mit Luft und andererseits zur Erzielung einer Linsen-Wirkung mit Flüssigkeiten, wie etwa Alkohol, gefüllt werden können.

Die DE 39 19 125 A1 offenbart einen schwimmfähigen Solarzellenkollektor geringer Dichte, dessen Photovoltaik-Zellen wasserdicht in transparenten Kunststoff eingebettet sind, wobei zwischen den Photovoltaik-Zellen Spüllöcher angeordnet sind, welche der Oberflächenreinigung dienen oder zu hohen Wasserdruck bei Wellengang vermeiden sollen.

Die DE 199 08 645 A1 offenbart einen schwimmenden Sonnenkollektor mit einer wasserdicht in transparente Folie eingebetteten Dünnschicht-Photovoltaik, wobei der Kollektor Laschen oder Löcher aufweist, durch die Stäbe aus Holz oder Bambus eingeschoben werden können, die den Kollektor aufspannen und die Schwimmfähigkeit sichern.

Den bisher im Stand der Technik bekannten Lösungen schwimmender photovoltaischer Systeme in Form von Folienlaminaten haftet der Nachteil einer mangelnden Begehbarkeit an. Üblicherweise sind daher Wartung und Instandhaltung während des Betriebs relativ schwierig. Für die Erfindung bestand daher die Aufgabe, eine schwimmende Abdeckfolie für eine Wasseroberfläche bzw. für ein Flüssigkeitsreservoir bereitzustellen, welches mit einem Solarmodul, vorzugsweise einer Dünnschicht-Photovoltaik versehen ist, welche dabei aber begehbar ist, so dass Abdeckfolie und Solarmodul ohne Probleme während des Betriebes gewartet werden können.

Gelöst wird diese Aufgabe durch die Merkmale des Hauptanspruchs. Weitere vorteilhafte Ausbildungen sind in den Unteransprüchen offenbart.

Dabei ist die Abdeckfolie eines Flüssigkeitsreservoirs aus einzelnen, an den Rändern miteinander verbundenen, vorzugsweise verschweißten oder verklebten länglichen Folienbahnen zusammengesetzt, wobei jede Folienbahn im unteren Bereich eine schwimmfähige Trägerfolie aus Kunststoff aufweist.

Die der Flüssigkeitsoberfläche gegenüberliegende und nach außen weisende Oberfläche der Trägerfolie ist mit einem länglich ausgebildeten Solarmodul belegt, vorzugsweise mit einem bahnförmigen Folien-Laminat, welches mindestens eine Lage aus dünnschichtigen Photovoltaik-Zellen beinhaltet und auf der Außenseite der Photovoltaik-Zellen eine oder mehrere Schichten aus lichtdurchlässigem Kunststoff aufweist. Die Solarmodule können auch solar-thermische Module sein, die in ihrem Inneren Einrichtungen zum Durchleiten einer Kühl- oder Wärmeträgerflüssigkeit aufweisen, z.b. rohrförmige Strukturen, Kapillaren oder offenporige Kunststoffstrukturen..

Die Breite des Solarmoduls bzw. des Folien-Laminats ist im Verhältnis zur Breite der Folienbahn geringer und so ausgebildet, dass auf jeder Folienbahn ein nicht mit Solarmodul oder Folien-Laminat belegter begehbarer und trittfester Streifen von Trägermaterial ausgebildet ist. Zusätzlich ist die Abdeckfolie an ihren Rändern mit den Begrenzungswänden des Flüssigkeitsreservoirs fest verbunden.

Ein solche erfindungsgemäße Ausbildung lässt auf jeder Folienbahn einen trittfesten Streifen entstehen, wobei unter anderem und neben der Schwimmfähigkeit auch die Anbindung der Folien untereinander und die Verbindung am Rand des Reservoirs ein Einsinken verhindert und eine sichere Standfläche auf jedem Streifen bereitstellt.

Eine vorteilhafte Weiterbildung besteht darin, dass die Trägerfolie mit Festigkeitsträgern oder Verstärkungselementen versehen ist, z. B. mit Geweben aus Textilien, Fasern, Garnen oder aus Kunststoffen, oder auch mit so genannten Corde unterschiedlicher Materialien verstärkt ist. Auch die erhöht die Belastbarkeit der Trägerfolie insbesondere im Hinblick auf Trittfestigkeit.

Eine weitere vorteilhafte Ausbildung besteht darin, dass die Trägerfolie aus mehreren Lagen aufgebaut ist und mindestens eine Schicht aus geschäumtem Kunststoff aufweist, ggf. einem wasserdicht versiegelten oder geschlossen-porigen geschäumten Kunststoff. Dies erhöht den Auftrieb bzw. die Schwimmfähigkeit der gesamten Folienkonstruktion und führt insbesondere bei fester Verbindung der Abdeckfolie an ihren Rändern mit den Begrenzungswänden des Flüssigkeitsreservoirs zu einer besonders stabil sich ausbildenden Trittfestigkeit der begehbaren Bereiche jeder Folie.

Eine weitere vorteilhafte Ausbildung besteht darin, dass mindestens die mit der Flüssigkeitsoberfläche in Berührung kommenden Folienteile aus lebensmittelrechtlich unbedenklichen Kunststoffmaterialen bestehen, z. B. gemäß der jeweils gültigen Ausführung des US Standard NSF/ANSI 61, z.B der NSF/ANSI 61-2010a oder anderen nationalen oder internationalen lebensmittelrechtlichen oder wasserrechtlichen Standards oder Normen ausgebildet sind. Damit ist ohne Weiteres eine Anwendung der abdeckfolie für Trinkwasserreservoire möglich.

Eine weitere vorteilhafte Ausbildung besteht darin, dass die Photovoltaik-Zellen in Kunststoffschichten eingebettet und durch letztere von der Trägerfolie getrennt sind. Dies schützt die üblicherweise verwendeten Dünnschicht- Photovoltaik-Zellen gegen Beschädigungen und sorgt auch für eine dehnungstolerante nachgiebige Lagerung für empfindliche Konstruktionen von Silicium- oder Silber-Wafern.

Insbesondere besteht eine in diesem Sinne weitere vorteilhafte Ausbildung darin, dass die mindestens eine Kunststoffschicht zwischen Photovoltaik-Zellen und Trägerfolie so dehnbar ausgebildet ist, dass Zugkräfte zwischen Trägerfolie und Photovoltaik-Zellen kompensiert werden. Damit kann die begehbare Trägerfolie auch mit starken Zugkräften/Trittkräften belastet werden, ohne dass diese auf die empfindlichen Dünnschicht- Photovoltaik-Zellen oder deren ebenfalls eingebettet Zuleitungen übertragen werden.

Eine weitere vorteilhafte Ausbildung besteht darin, dass die Abdeckfolie unter Aufbringen einer Zugspannung an ihren Rändern mit den mit den Begrenzungswänden des Flüssigkeitsreservoirs verbunden ist. Dies erhöht im Zusammenwirken mit der durch den Auftrieb entstehenden "Ballonspannung" noch einmal die Belastbarkeit und Trittfestigkeit der Trägerfolie und somit der gesamten Abdeckfolie.

Eine weitere vorteilhafte Ausbildung besteht darin, dass jeweils zwei nebeneinanderliegende Folienbahnen so miteinander verbunden sind, dass die begehbaren Streifen von Trägermaterial aneinanderstoßen, also um ihre senkrecht zur Flüssigkeitsoberfläche stehende Hochachse um 180° gedreht miteinander verklebt oder verschweißt werden. Dies führt zu einer Verbreiterung der "Trittfläche" und erleichtert somit die Begehbarkeit flächenmäßig größerer Abdeckfolien, etwa solcher mit über 2000 m² Abdeckfläche.

Anhand eines Ausführungsbeispieles soll die Erfindung näher erläutert werden.

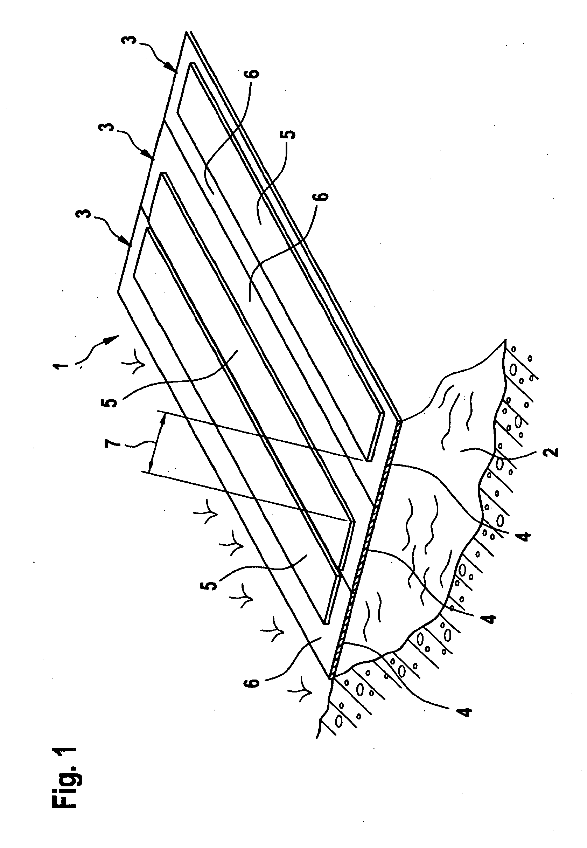

Die Fig. 1 zeigt eine Abdeckfolie 1 eines Trinkwasserreservoirs 2, die aus einzelnen, an den Rändern miteinander verbundenen länglichen Folienbahnen 3 zusammengesetzt ist.

Jede Folienbahn weist eine unten liegende schwimmfähige Trägerfolie 4 aus Kunststoff auf.

Die der Flüssigkeitsoberfläche gegenüberliegende und nach außen weisende Oberfläche der Trägerfolie ist mit einem länglich ausgebildeten bahnförmigen Folien-Laminat 5 belegt, welches eine hier nicht näher dargestellte Lage aus dünnschichtigen Photovoltaik-Zellen beinhaltet mit mehreren Schichten aus lichtdurchlässigem Kunststoff und auf ihrer Außenseite.

Die Breite des Folien-Laminats ist im Verhältnis zur Breite der Folienbahn geringer und so ausgebildet, dass auf jeder Folienbahn ein nicht mit Folien-Laminat belegter begehbarer und trittfester Streifen 6 von Trägermaterial ausgebildet ist. Hier entspricht die Breite des Folienlaminats etwa der Hälfte der Breite einer Folienbahn.

Die Abdeckfolie an ihren Rändern mit den Begrenzungswänden des Flüssigkeitsreservoirs fest verbunden und weist hier nicht näher dargestellte Festigkeitsträger zur Verstärkung auf.

Jeweils zwei nebeneinanderliegende Folienbahnen sind um ihre senkrecht zur Flüssigkeitsoberfläche stehende Hochachse um 180° gedreht miteinander verbunden, dass die begehbaren Streifen von Trägermaterial aneinanderstoßen und so ein verbreiterter "Trittstreifen" also eine verbreiterte Trittfläche 7 entsteht.

### Bezugszeichenliste

### (Teil der Beschreibung)

- 1: Abdeckfolie
- 2: Trinkwasserreservoir
- 3: Folienbahn
- 4: Trägerfolie
- 5: Folien-Laminat mit Dünnschicht-Photovoltaik
- 6: Trittfester Streifen
- 7: Verbreiterter Trittstreifen

## Patentansprüche

1. Schwimmende Abdeckfolie (1) eines Flüssigkeitsreservoirs (2), die aus einzelnen, an den Rändern miteinander verbundenen, vorzugsweise miteinander verschweißten oder verklebten länglichen Folienbahnen (3) zusammengesetzt ist, wobei die Abdeckfolie auf der Flüssigkeitsoberfläche des Reservoirs aufliegt und die folgenden Merkmale aufweist:
- jede Folienbahn (3) weist im unteren Bereich eine schwimmfähige Trägerfolie (4) aus Kunststoff auf,
- die der Flüssigkeitsoberfläche gegenüberliegende und nach außen weisende Oberfläche der Trägerfolie ist mit einem länglich ausgebildeten bahnförmigen Solarmodul (5) belegt,
- die Breite des Solarmoduls (5) ist im Verhältnis zur Breite der Folienbahn (3) geringer und so ausgebildet, dass auf jeder Folienbahn ein nicht mit Solarmodul belegter begehbarer und trittfester Streifen (6) von Trägermaterial ausgebildet ist,
wobei die Abdeckfolie (1) an ihren Rändern mit den Begrenzungswänden des Flüssigkeitsreservoirs (2) fest verbunden ist.

2. Abdeckfolie nach Anspruch 1, bei der das Solarmodul als längliches bahnförmiges Folien-Laminat (5) ausgebildet ist, welches mindestens eine Lage aus dünnschichtigen Photovoltaik-Zellen beinhaltet und auf der Außenseite der Photovoltaik-Zellen eine oder mehrere Schichten aus lichtdurchlässigem Kunststoff aufweist.

3. Abdeckfolie nach Anspruch 1 oder 2, bei der die Trägerfolie (4) mit Festigkeitsträgern oder Verstärkungselementen versehen ist.

4. Abdeckfolie nach Anspruch einem der Ansprüche 1 bis 3, bei der die Trägerfolie (4) aus mehreren Lagen aufgebaut ist und mindestens eine Schicht aus geschäumtem Kunststoff aufweist, insbesondere eine Schicht aus einem wasserdicht versiegelten oder geschlossen-porigen geschäumten Kunststoff.

5. Abdeckfolie nach einem der Ansprüche 1 bis 4 für ein Wasserreservoir, wobei mindestens die mit der Flüssigkeitsoberfläche in Berührung kommenden Folienteile aus lebensmittelrechtlich unbedenklichen Kunststoffmaterialen bestehen.

6. Abdeckfolie nach einem der Ansprüche 1 bis 5, bei der die Photovoltaik-Zellen in Kunststoffschichten eingebettet und durch letztere von der Trägerfolie (4) getrennt sind.

7. Abdeckfolie nach Anspruch 6, bei der die mindestens eine Kunststoffschicht zwischen Photovoltaik-Zellen und Trägerfolie (4) so dehnbar ausgebildet ist, dass Zugkräfte zwischen Trägerfolie und Photovoltaik-Zellen kompensiert werden.

8. Abdeckfolie nach einem der Ansprüche 1 bis 7, die unter Aufbringen einer Zugspannung an ihren Rändern mit den mit den Begrenzungswänden des Flüssigkeitsreservoirs verbunden ist.

9. Abdeckfolie nach einem der Ansprüche 1 bis 8, bei der jeweils zwei nebeneinanderliegende Folienbahnen so miteinander verbunden sind, dass die begehbaren, trittfesten Streifen (6) von Trägermaterial aneinanderstoßen.

## Claims

1. Floating cover sheet (1) of a liquid reservoir (2), which is made up of individual elongate sheet panels (3) that are connected to one another at the edges, preferably welded or adhesively bonded to one another, the cover sheet lying on the surface of the liquid in the reservoir and having the following features:
- each sheet panel (3) has in the lower region a buoyant carrier sheet (4) of plastic,
- the surface of the carrier sheet that is opposite from the surface of the liquid and facing outward is covered by a solar module (5) of an elongate form, in the form of a panel,
- the width of the solar module (5) is smaller in relation to the width of the sheet panel (3) and is formed such that a strip (6) of carrier material that is not covered by the solar module, can be walked on and is tread-resistant is formed on each sheet panel,
the cover sheet (1) being firmly connected at its edges to the bounding walls of the liquid reservoir (2).

2. Cover sheet according to Claim 1, in which the solar module is designed as an elongate sheet laminate (5) in the form of a panel, which comprises at least one layer of thin-film photovoltaic cells and has on the outer side of the photovoltaic cells one or more layers of transparent plastic.

3. Cover sheet according to Claim 1 or 2, in which the carrier sheet (4) is provided with strengthening supports or reinforcing elements.

4. Cover sheet according to Claim one of Claims 1 to 3, in which the carrier sheet (4) is made up of multiple layers and has at least one layer of expanded plastic, in particular a layer of a watertight-sealed or closed-cell expanded plastic.

5. Cover sheet according to one of Claims 1 to 4 for a water reservoir, at least the parts of the sheet that come into contact with the surface of the liquid consisting of plastics materials that are suitable for food contact applications.

6. Cover sheet according to one of Claims 1 to 5, in which the photovoltaic cells are embedded in layers of plastic and are separated by the latter from the carrier sheet (4).

7. Cover sheet according to Claim 6, in which the at least one layer of plastic between the photovoltaic cells and the carrier sheet (4) is of a stretchable form so as to compensate for tensile forces between the carrier sheet and the photovoltaic cells.

8. Cover sheet according to one of Claims 1 to 7, which is connected at its edges to the to the bounding walls of the liquid reservoir while applying a tensile stress.

9. Cover sheet according to one of Claims 1 to 8, in which respectively two sheet panels lying next to one another are connected to one another in such a way that the strips (6) of carrier material that can be walked on and are tread-resistant butt against one another.

## Revendications

1. Feuille de couverture flottante (1) d'un réservoir de liquide (2), qui est composée de bandes de feuille allongées (3) individuelles, assemblées entre elles, de préférence soudées ou collées entre elles, au niveau des bords, la feuille de couverture reposant sur la surface du liquide du réservoir, et qui présente les caractéristiques suivantes :
- chaque bande de feuille (3) comporte dans la partie inférieure une feuille de support (4) pouvant flotter, en matière plastique,
- la surface de la feuille de support opposée à la surface du liquide et tournée vers l'extérieur est munie d'un module solaire (5) en forme de bande allongée,
- la largeur du module solaire (5) est plus faible par rapport à la largeur de la bande de feuille (3) et conçue telle que sur chaque bande de feuille est ménagée une bande (6) de matériau de support, accessible et sur laquelle on peut marcher, non recouverte de module solaire,
la feuille de couverture (1) étant fixée au niveau de ses bords aux parois de délimitation du réservoir de liquide (2).

2. Feuille de couverture selon la revendication 1, pour laquelle le module solaire est conçu sous forme de stratifié de feuilles (5) en forme de bande allongée, qui renferme au moins une couche de cellules photovoltaïques en couche mince et, sur la face externe des cellules photovoltaïques, comporte une ou plusieurs couches de matière plastique transparente.

3. Feuille de couverture selon la revendication 1 ou 2, dans laquelle la feuille de support (4) est munie de raidisseurs ou d'éléments de renforcement.

4. Feuille de couverture selon la revendication l'une quelconque des revendications 1 à 3, dans laquelle la feuille de support (4) est constituée de plusieurs couches et comporte au moins une couche de matière plastique expansée, en particulier une couche d'une matière plastique expansée à pores fermés ou scellée pour être imperméable à l'eau.

5. Feuille de couverture selon l'une quelconque des revendications 1 à 4, pour un réservoir d'eau, au moins les parties de la feuille qui entrent en contact avec la surface du liquide étant constituées de matériaux en matière plastique sans inconvénients selon la législation sur les denrées alimentaires.

6. Feuille de couverture selon l'une quelconque des revendications 1 à 5, dans laquelle les cellules photovoltaïques sont incluses dans des couches de matière plastique et sont séparées par ces dernières de la feuille de support (4).

7. Feuille de couverture selon la revendication 6, dans laquelle ladite au moins une couche de matière plastique entre cellules photovoltaïques et feuille de support (4) est conçue extensible, de sorte que les forces de traction entre feuille de support et cellules photovoltaïques sont compensées.

8. Feuille de couverture selon l'une quelconque des revendications 1 à 7, qui est reliée aux aux parois de délimitation du réservoir de liquide par application d'une contrainte de traction sur les bords de celle-ci.

9. Feuille de couverture selon l'une quelconque des revendications 1 à 8, dans laquelle chaque fois deux bandes de feuille contiguës sont assemblées entre elles, de sorte que les bandes (6) de matériau de support accessibles, sur lesquelles on peut marcher, sont jointives.
